# EUROPEAN PATENT APPLICATION

(11) **EP 3 407 390 A1**
(43) Date of publication of application: **28.11.2018**
(21) Application number: 18155534.3
(22) Date of filing: 07.02.2018
(51) Int. Cl.: H01L 31/0224, H01L 31/05, H01L 31/0463, H01L 31/0465, H01L 31/0445

(54) **COMPOUND SEMICONDUCTOR SOLAR CELL, MODULE AND FABRICATING METHODS THEREOF**

(30) Priority: 22.05.2017 KR 20170062879
(71) Applicant: LG Electronics Inc., Yeongdeungpo-gu Seoul 07336 (KR)
(72) Inventor: LEE, Huijae, 08592 Seoul (KR); SHIN, Junoh, 08592 Seoul (KR); AN, Kitae, 08592 Seoul (KR); CHEUN, Hyeunseok, 08592 Seoul (KR)
(74) Representative: Katérle, Axel

(57) **Abstract**

A compound solar cell (10) includes a compound semiconductor layer (11), a first electrode (13) and a second electrode (15) respectively formed on a first surface and a second surface of the compound semiconductor layer, a support substrate (17) formed on the second electrode, an opening (111) formed in the compound semiconductor layer, the opening positioned along a first longitudinal side of the compound semiconductor layer to expose the second electrode, and a through hole (TH) connected to the opening and formed to penetrate the second electrode and the support substrate.

## Description

### CROSS-REFERENCE TO RELATED APPLICATION

This application claims priority to and the benefit of Korean Patent Application No. 10-2017-0062879 filed on May 22, 2017, the disclosure of which is hereby incorporated by reference in its entirety.

### BACKGROUND

### Field

Embodiments of the present disclosure relate to a compound solar cell module in which compound solar cells are partially overlapped, stacked and connected, a method of manufacturing the same, and a compound solar cell used therefor.

### Description of the Related Art

A compound semiconductor is not a single element, such as silicon or germanium, but two or more kinds of elements that are combined and operated as a semiconductor. Currently, various kinds of compound semiconductors have been developed and used in various fields.

Among them, the compound semiconductor solar cell includes a III-V compound semiconductor such as gallium arsenide (GaAs), indium phosphorus (InP), gallium aluminum arsenide (GaAlAs), gallium indium arsenide (GaInAs), cadmium sulfur (CdS), a II-VI compound semiconductor such as cadmium tellurium (CdTe) or zinc sulfide (ZnS), or a I-III-VI compound semiconductor such as copper indium selenium (CuInSe2).

The compound semiconductor solar cell has a very thin thickness, and a support substrate is usually used on one side of the solar cell for easy handling. However, when the compound semiconductor solar cells provided with the support substrate are overlapped and connected, it is difficult to electrically connect the solar cells due to the support substrate positioned between them.

### SUMMARY

The present disclosure provides a compound solar cell to be easily connected to another compound solar cell using a support substrate.

In one aspect, a compound solar cell includes a compound semiconductor layer, a first electrode and a second electrode respectively formed on a first surface and a second surface of the compound semiconductor layer, a support substrate formed on the second electrode, an opening formed in the compound semiconductor layer, the opening positioned along a first longitudinal side of the compound semiconductor layer to expose the second electrode, and a through hole connected to the opening and formed to penetrate the second electrode and the support substrate.

The second electrode is exposed to the outside through the opening.

The first electrode includes a bus electrode formed to extend along a second longitudinal side opposite to the first longitudinal side, and a finger electrode formed to extend from the bus electrode toward the first longitudinal side.

The opening is positioned apart from the finger electrode in a longitudinal direction of the finger electrode or between the finger electrodes.

The finger electrode may be one of a plurality of finger electrodes, including at least on first finger electrode having a first length and extending between the openings to the first longitudinal side and at least one second finger electrode extending toward the opening and having a second length shorter than the first length.

The opening extends along the first longitudinal side and has a slit shape.

The opening exposes an entire side of the second electrode in a longitudinal direction.

In another aspect, a compound solar cell module includes a plurality of solar cells partially overlapped in overlap regions. Each one of the plurality of solar cells includes a compound semiconductor layer, a first electrode and a second electrode respectively formed on a first surface and a second surface of the compound semiconductor layer, an opening formed in the compound semiconductor layer, the opening positioned along a first longitudinal side of the compound semiconductor layer to expose the second electrode, and a through hole connected to the opening and formed to penetrate the second electrode and the support substrate. The through hole of a first solar cell among the plurality of solar cells is positioned on the first electrode of a second solar cell among the plurality of solar cells in an overlap region of the first solar cell and the second solar cell. The first solar cell and the second solar cell are electrically and physically connected by a conductive layer filling the through hole of the first solar cell.

The conductive layer is formed to extend over the second electrode of the first solar cell partially exposed through the opening of the first solar cell, and is positioned apart from a side surface of the through hole of the compound semiconductor layer of the first solar cell.

The compound semiconductor layer and the conductive layer are insulated by an insulating material.

The first solar cell and the second solar cell are bonded by a non-conductive adhesive in the overlap region.

In another aspect, a method for manufacturing a compound solar cell is provided. The method includes forming a stack including a compound semiconductor layer, a first electrode and a second electrode respectively formed on front and back surfaces of the compound semiconductor layer, and a support substrate formed on the second electrode, forming an opening that partially exposes the second electrode, forming a mesa line dividing the stack into a plurality of cells, forming a through hole by removing a portion of the second electrode and a portion of the support substrate positioned under the opening, and scribing the stack into a plurality of solar cells along the mesa line.

The operation of forming the mesa line and the operation of forming the through hole are simultaneously performed by a mesa etching process. The operation of scribing the stack and the operation of forming the through hole are simultaneously performed by a laser scribing process.

The laser scribing process is performed by a UV laser having a power of 1 W to 3 W.

In another aspect, a method for manufacturing a compound solar cell module is provided. The compound solar cell includes a plurality of compound solar cells respectively having a compound semiconductor layer, a first electrode and a second electrode respectively formed on a first surface and a second surface of the compound semiconductor layer, a support substrate formed on the second electrode, an opening formed in the compound semiconductor, the opening positioned along a first longitudinal side of the compound semiconductor layer to expose the second electrode, and a through hole connected to the opening and formed to penetrate the second electrode and the support substrate. The method includes disposing the through hole of a first solar cell among the plurality of solar cells toward the first electrode of a second solar cell among the plurality of solar cells, and applying and curing a conductive adhesive to the through hole of the first solar cell. The conductive adhesive fills a part of the opening of the first solar cell and is formed on a surface of the second electrode of the first solar cell exposed by the opening of the first solar cell.

The conductive adhesive has a viscosity of 8,000 cps to 12,000 cps.

The operation of disposing the through hole further includes applying a non-conductive adhesive to a region where the first solar cell and the second solar cell are joined to each other.

According to the embodiment of the disclosure, the electrodes of the neighboring compound solar cells are exposed through the through holes, so that the neighboring compound solar cells may be easily connected using the conductive adhesive.

### BRIEF DESCRIPTION OF THE DRAWINGS

FIG. 1 is a perspective view illustrating a compound solar cell, according to an embodiment of the disclosure.
FIG. 2 is a view illustrating in detail an interlayer structure of the compound solar cell illustrated in FIG. 1, according to an embodiment of the disclosure.
FIG. 3 is a schematically cross-sectional view taken along line A-A' of FIG. 1, according to an embodiment of the disclosure.
FIG. 4 is a plan view of the compound solar cell illustrated in FIG. 1, according to an embodiment of the disclosure.
FIG. 5 is a view for explaining an arrangement of an opening and a through hole of the compound solar cell illustrated in FIG. 1, according to an embodiment of the disclosure.
FIG. 6 is a plan view of a compound solar cell, according to an embodiment of the disclosure.
FIG. 7 is a plan view of a compound solar cell, according to an embodiment of the disclosure.
FIG. 8 is a plan view of a compound solar cell, according to an embodiment of the disclosure.
FIG. 9 is a view illustrating a compound solar cell module in which a compound solar cell illustrated in FIG. 1 is used, according to an embodiment of the disclosure.
FIG. 10 is a schematically cross-sectional view taken along line B-B' of FIG. 9, respectively.
FIG. 11 is a schematically cross-sectional view taken along line C-C' of FIG. 9.
FIG. 12 is a view for explaining the arrangement between an opening and a conductive layer, according to an embodiment of the disclosure.
FIG. 13 is a schematic view illustrating a mesa etching process and a scribing process, according to an embodiment of the disclosure.
FIG. 14 is a schematic view illustrating formation of an opening through a mesa etching process, according to an embodiment of the disclosure.
FIGS. 15 and 16 are schematic views illustrating formation of through holes through a scribing process.
FIG. 17 is a flowchart illustrating a method of manufacturing a compound solar cell module according to an embodiment of the present disclosure.
FIG. 18 is a schematic view for explaining a process of applying a conductive adhesive, according to an embodiment of the disclosure.

### DETAILED DESCRIPTION OF THE EMBODIMENTS

Reference will now be made in detail to embodiments of the disclosure, examples of which are illustrated in the accompanying drawings.

This disclosure may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts may obscure the embodiments of the disclosure. In addition, the various embodiments shown in the drawings are illustrative and may not be drawn to scale to facilitate illustration. The shape or structure may also be simplified for purposes of illustration.

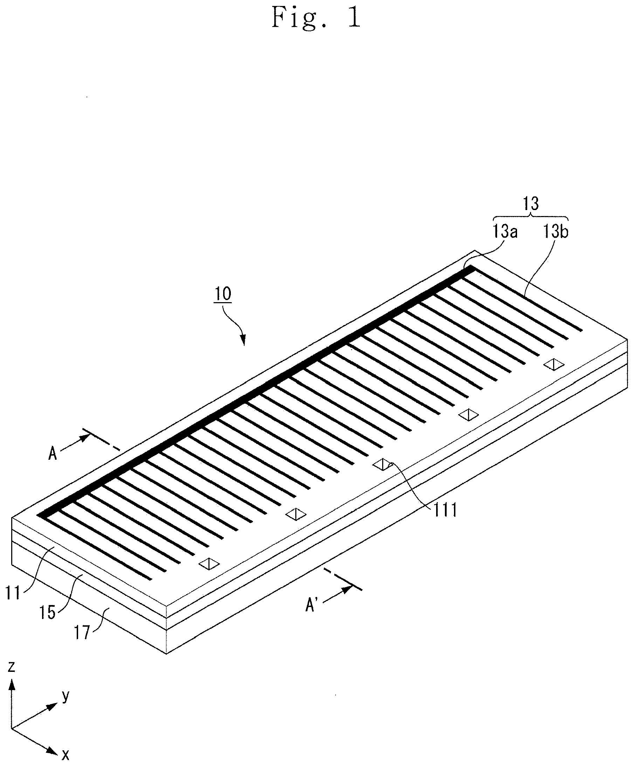

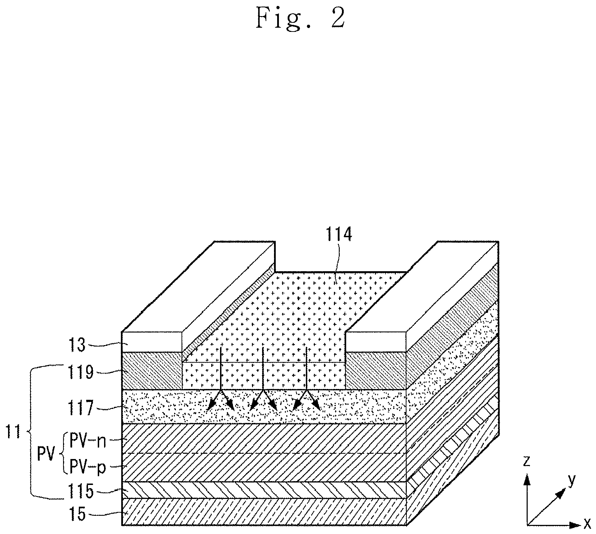

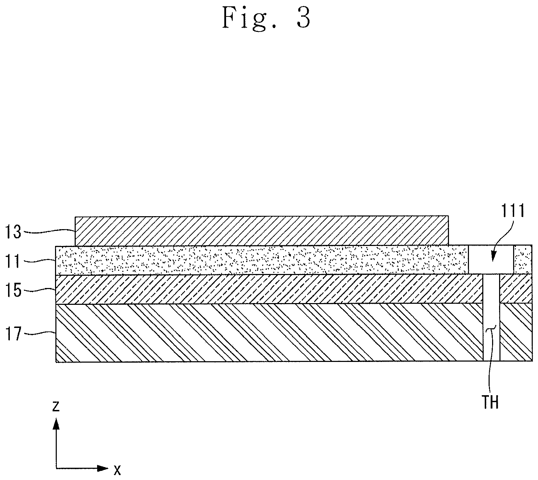

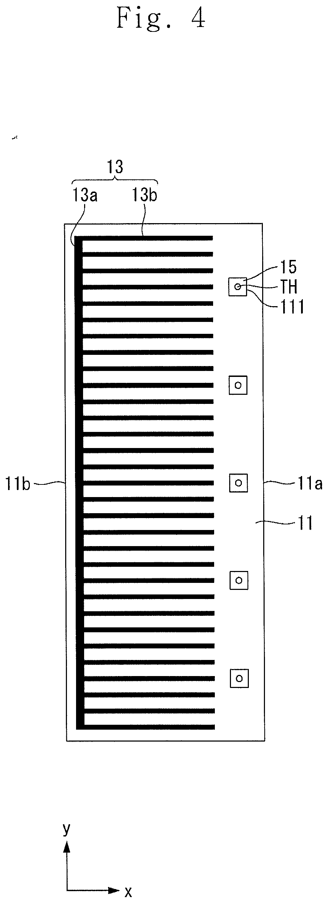

Hereinafter, a compound solar cell according to an embodiment of the disclosure will be described in detail with reference to the accompanying drawings. FIG. 1 is a perspective view illustrating a compound solar cell according to an embodiment of the disclosure. FIG. 2 is a view illustrating in detail the interlayer structure of the compound solar cell illustrated in FIG. 1 according to an embodiment of the disclosure. FIG. 3 is a schematically cross-sectional view taken along line A-A' of FIG. 1. FIG. 4 is a plan view of a compound solar cell illustrated in FIG. 1.

Referring to FIGS 1 to 4, a compound solar cell 10 according to an embodiment of the disclosure includes a compound semiconductor layer 11, a first electrode 13, and a second electrode 15 respectively formed on a front surface (first surface) and a rear surface (second surface) of the compound semiconductor layer 11, and a support substrate 17 formed on a rear surface of the second electrode 15. More specifically, the compound semiconductor layer 11 may have a structure as illustrated in FIG. 2.

The compound solar cell 10 includes a light absorbing layer PV, a window layer 117 positioned on a front surface of the light absorbing layer PV, the first electrode 13 (hereinafter referred to as a front electrode) positioned on a front surface of the window layer 117, a front contact layer 119 positioned between the window layer 117 and the front electrode 13, an anti-reflection layer 114 positioned on the window layer 117, a rear contact layer 115 positioned on a rear surface of the light absorbing layer PV, and the second electrode 15 (hereinafter referred to as a rear electrode) positioned on a rear surface of the rear contact layer 115.

At least one of the anti-reflection layer 114, the window layer 117, the front contact layer 119, and the rear contact layer 115 may be omitted. However, in the following description, an example will be described wherein the layers 114, 115, 117, and 119 are provided as shown in FIG. 2.

The light absorbing layer PV may be formed to include a III-VI group semiconductor compound. For example, GaInP compound containing gallium (Ga), indium (In) and phosphorus (P), or GaAs compound containing gallium (Ga), and arsenic (As). Hereinafter, the light absorbing layer PV includes a GaAs compound as an example.

The light absorbing layer PV includes a p-type semiconductor layer PV-p doped with an impurity of a first conductivity type, for example, a p-type impurity, and an n-type semiconductor layer PV-n doped with an impurity of a second conductivity type, for example, an n-type impurity.

Although not shown, the light absorbing layer PV may further include a rear front layer positioned on the rear surface of the p-type semiconductor layer PV-p.

The p-type semiconductor layer PV-p is formed by doping a compound with an impurity of the first conductivity type, that is, a p-type impurity. The n- type semiconductor layer PV-n is formed by doping a compound with an impurity of the second conductivity type, that is, an n-type impurity.

Here, the p-type impurity may be selected from carbon, magnesium, zinc, or a combination thereof, and the n-type impurity may be selected from silicon, selenium, tellurium, or a combination thereof.

The n-type semiconductor layer PV-n may be disposed on a region close to the front electrode 13, and the p-type semiconductor layer PV-p may be disposed on a region directly below the n-type semiconductor layer PV-n and close to the rear electrode 15.

That is, a distance between the n-type semiconductor layer PV-n and the front electrode 13 may be smaller than a distance between the p-type semiconductor layer PV-p and the front electrode 13, and a distance between the n-type semiconductor layer PV-n and the rear electrode 15 may be larger than a distance between the p-type semiconductor layer PV-p and the rear electrode.

Thus, because a pn junction in which the p-type semiconductor layer PV-p and the n-type semiconductor layer PV-n are joined is formed in the light absorbing layer PV, electron-hole pairs generated by the light are separated into electrons and holes by an internal potential difference formed by the pn junction of the light absorbing layer PV so that electrons move toward the n-type semiconductor layer PV-n and holes move toward the p-type semiconductor layer PV-p.

Therefore, the holes generated in the light absorbing layer PV move to the rear electrode 15 through the rear contact layer 115, and the electrons generated in the light absorbing layer PV moves to the front electrode 13 through the front contact layer 119 and the window layer 117.

Alternatively, the p-type semiconductor layer PV-p may be disposed on a region close to the front electrode 13, while the n-type semiconductor layer PV-n may be disposed on a region close to the rear electrode 15 and directly below the p-type semiconductor layer PV-p. In this case, the holes generated in the light absorbing layer PV move to the front electrode 13 through the front contact layer 119 and the window layer 117 and the electrons generated in the light absorbing layer PV move to the rear electrode 15 through the rear contact layer 115.

A BSF (back surface field) layer may be further positioned between the light absorbing layer PV and the rear contact layer 115. The BSF layer may have the same conductivity type as one of the n-type semiconductor layer PV-n and the p-type semiconductor layer PV-p, which may be in direct contact with the BSF layer. The BSF layer may be formed of the same material or different materials as the window layer 117. In one example, the BSF layer may be formed of AlGaInP.

In order to effectively block charges (holes or electrons) to be moved to the front electrode 13 from moving toward the rear electrode 15, the BSF layer may be formed on the entire rear surface of a layer of the light absorbing layer PV that directly contacts the BSF layer, that is, the rear surface of the n-type semiconductor layer PV-n or the p-type semiconductor layer PV-p.

For example, when the BSF layer may be formed on the rear surface of the p-type semiconductor layer PV-p, the BSF layer functions to block electrons from moving toward the rear electrode 15. The BSF layer may be positioned on the entire rear surface of the p-type semiconductor layer PV-p to effectively prevent electrons from moving toward the rear electrode 15.

The light absorbing layer PV having such a structure may be formed on a mother substrate by a metal organic chemical vapor deposition (MOCVD) method, a molecular beam epitaxy (MBE) method, or any other suitable method for forming an epitaxial layer.

The p-type semiconductor layer PV-p and the n-type semiconductor layer PV-n may be made of the same material having the same band gap as each other to form a homogeneous junction. Alternatively, the p-type semiconductor layer PV-p and the n-type semiconductor layer PV-n may be made of different materials to form a heterojunction.

The window layer 117 may be formed between the light absorbing layer PV and the front electrode 13 and may be formed by doping a III-VI group semiconductor compound, for example, AlInP, with an impurity of the second conductivity type, that is, an n-type impurity.

Here, aluminum (Al) may be included in the window layer 117 such that the energy band gap of the window layer 117 may be higher than the energy band gap of the light absorbing layer PV.

When the p-type semiconductor layer PV-p is positioned on the n-type semiconductor layer PV-n and the window layer 117 is positioned on the p-type semiconductor layer PV-p, the window layer 117 may include an impurity having the first conductivity type, that is, a p-type impurity. Alternatively, the window layer 117 may not include n-type or p-type impurities.

The window layer 117 serves to passivate the front surface of the light absorbing layer PV. Therefore, when the carrier (electrons or holes) moves to the front surface of the light absorbing layer PV, the window layer 117 may prevent the carriers from recombining on the front surface of the light absorbing layer PV.

Because the window layer 117 is disposed on the front surface of the light absorbing layer PV, that is, on the light incident surface, the window layer 117 may have an energy band gap higher than the energy band gap of the light absorbing layer PV in order not to substantially absorb the light incident on the light absorbing layer PV.

The anti-reflection layer 114 may be positioned in a region on the front surface of the window layer 117 other than the region where the front electrode 13 and/or the front contact layer 119 are positioned. Alternatively, the anti-reflection layer 114 may be disposed on the front contact layer 119 and the front electrode 13 as well as the exposed window layer 117.

In this case, although not illustrated, the compound solar cell 10 may further include a bus bar electrode physically connecting the plurality of front electrodes 13, and the bus bar electrode may not be covered with the anti-reflection layer 114 and may be exposed to the outside. The anti-reflection layer 114 having such a structure may include magnesium fluoride, zinc sulfide, titanium oxide, silicon oxide, derivatives thereof, or a combination thereof.

The front electrode 13 may be formed to extend in a second direction (y-axis direction in the figures), and the front electrode 13 may be formed in plural along a first direction (x-axis direction in the figures) orthogonal to the second direction. The front electrode 13 having such a structure may be formed to include an electrically conductive material and may be formed of gold (Au), platinum (Pt), titanium (Ti), tungsten (W), silicon (Ni), magnesium (Mg), palladium (Pd), copper (Cu), and germanium (Ge).

The front contact layer 119 located between the window layer 117 and the front electrode 13 may be formed by doping a Group III-VI semiconductor compound with an impurity. Here, the impurity in the front contact layer 119 may have a doping concentration higher than the impurity doping concentration of the window layer 117.

The front contact layer 119 forms ohmic contact between the window layer 117 and the front electrode 13. If the front electrode 13 directly contacts the window layer 117, the impurity doping concentration of the window layer 117 may be low, so that the ohmic contact between the front electrode 13 and the light absorbing layer PV is not formed well. Therefore, the carrier moved to the window layer 117 cannot easily move to the front electrode 13 and may be destroyed.

However, when the front contact layer 119 is formed between the front electrode 13 and the window layer 117, the carrier may be smoothly moved by the front contact layer 119 forming the ohmic contact with the front electrode 13. The short circuit current density (Jsc) of the compound solar cell 10 may be increased. Thus, the efficiency of the solar cell may be further improved.

In order to form an ohmic contact with the front electrode 13, the front contact layer 119 may be formed of GaAs or AlGaAs having good electrical conductivity. The doping concentration of the doped impurity in the front contact layer 119 may be higher than the doping concentration of the doped impurity in the window layer 117. In some embodiments, the front contact layer 119 may be formed in the same shape as the front electrode 13.

When the light absorbing layer PV includes the BSF layer, the rear contact layer 115 positioned on a rear surface of the BSF layer may be positioned on the entire rear surface of the light absorbing layer PV. The rear contact layer 115 may be formed by doping a Group III-VI semiconductor compound with an impurity of the first conductivity type at a higher doping concentration than the p-type semiconductor layer PV-p.

The rear contact layer 115 may be formed of GaAs or AlGaAs having good electrical conductivity to form an ohmic contact with the rear electrode 15 and may improve the short circuit current density (Jsc) of the compound solar cell 10. Thus, the efficiency of the solar cell may be further improved.

Each one of the thickness of the front contact layer 119 and the thickness of the rear contact layer 115 may be 1110 nm to 1130 nm. For example, the front contact layer 119 may have a thickness of 1110 nm and the rear contact layer 115 may have a thickness of 1130 nm.

The rear electrode 15 positioned on a rear surface of the rear contact layer 115 may be formed as a sheet-like conductor located on the entire rear surface of the rear contact layer 115, unlike the front electrode 13. That is, the rear electrode 15 may be formed of a sheet electrode positioned on the entire rear surface of the rear contact layer 115.

Like the front electrode 13, the rear electrode 15 may be formed of a metal such as gold (Au), platinum (Pt), titanium (Ti), tungsten (W), silicon (Si), nickel (Ni) (Mg), palladium (Pd), copper (Cu), and germanium (Ge).

Because the compound solar cell 10 according to an embodiment of the disclosure further includes an opening 111 and a through hole TH, when the compound solar cells 10 are stacked to form a module, it is possible to electrically and physically connect two adjacent compound solar cells with ease.

Here, the opening 111 may be formed by removing the compound semiconductor layer 11, so that the rear electrode 15, which is in surface connection with the compound semiconductor layer 11, may be exposed to the front side. The through hole TH is connected to the opening 111 and may be formed to penetrate the rear electrode 15 exposed through the opening 111 and a part of the support substrate 17 existing under the rear electrode 15.

In one example form, the front electrode 13 includes a bus electrode 13a formed along a second longitudinal side 11b in the longitudinal direction (y-axis direction in the figures) of the compound semiconductor layer 11 and a plurality of finger electrodes 13b extending in the first direction (x-axis direction in the figures) toward a first longitudinal side 11a.

The bus electrode 13a connects one end of each one of the finger electrodes 13b and may have a line width larger than the line width of each one of the finger electrodes 13b. The bus electrode 13a not only connects the finger electrodes 13b, but also functions as a pad when the solar cells are overlapped and connected.

The finger electrodes 13b may be formed in plural and arranged in parallel with the neighboring ones in the second direction (y-axis direction in the figures), and may have a striped arrangement as a whole.

The opening 111 may be disposed close to the first longitudinal side 11a of the compound semiconductor layer 11 apart from the finger electrodes 13b. The opening 111 may be formed in plural and may be spaced a predetermined distance from neighboring opening 111 in the second direction. The opening 111 may be positioned apart from the finger electrodes 13b in a longitudinal direction of the finger electrodes 13b (x-axis direction in the figures).

As shown in FIG. 1, the plane view of the opening 111 may be substantially square, but the disclosure is not limited thereto. The opening 111 may have various shapes such as a circular shape, an elliptical shape, and a polygonal shape.

A part of the rear electrode 15 hidden by the compound semiconductor layer 11 and particularly a part of the rear electrode 15 close to the first longitudinal side 11a may be exposed by the opening 111.

The through hole TH may be positioned so as to be connected to the opening 111. Here, the position to be connected means that the opening 111 and the through hole TH overlap and align with each other in the vertical direction (z-axis direction in the figures).

The through hole TH may be positioned on the center portion of the rear electrode 15 exposed by the opening 111 and may be formed so as to penetrate through the rear electrode 15 and the support substrate 17 positioned below the rear electrode 15.

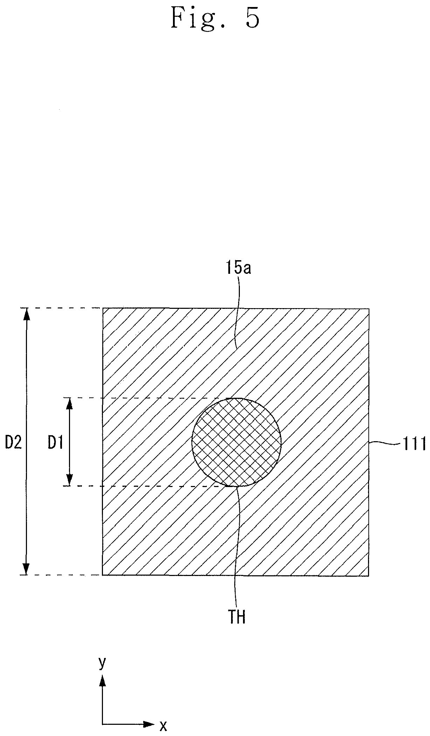

As illustrated in FIG. 5, the opening 111 may be formed on the compound semiconductor layer 11 so as to have a substantially square shape, and a part 15a of the second electrode 15 may be exposed to the outside through the opening 111 due to the opening 111.

The through hole TH may be located in the center portion of the part 15a of the second electrode 15 exposed by the opening 111. Here, the diameter of the through hole TH having a substantially circular shape is D1, and the width and length of the opening 111 are each D2 (e.g., a square shaped opening), wherein D2 is larger than D1. Thus, the part 15a of the second electrode 15 may be exposed between the through hole TH and the opening 111.

In one example, a conductive layer may be formed up to the part 15a of the exposed second electrode, so that neighboring solar cells may be physically and electrically connected to each other stably. This will be described in detail later.

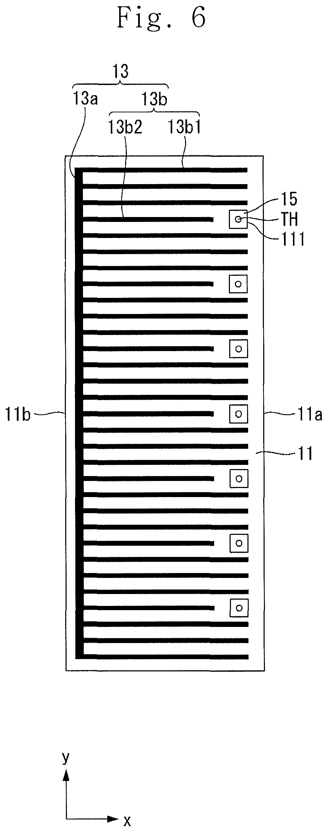

In the above description, the opening 111 may be located away from the finger electrode 13b, but the disclosure is not limited this configuration. The opening 111 may be located between the finger electrodes 13b when the pitch of the finger electrodes 13b is sufficiently large and may be arranged as shown in FIG. 6 even if the pitch of the finger electrodes 13b is dense.

As illustrated in FIG. 6, the finger electrodes 13b include a plurality of first finger electrodes 13b1 having a first length and extending between the openings 111 toward the first longitudinal side 11a and a plurality of second finger electrodes 13b2 extending toward the openings 111 and having a second length shorter than the first length.

One end of each one of the first finger electrodes 13b1 may be connected to the bus electrode 13a. The other end of each one of the first finger electrodes 13b1 extends toward the first longitudinal side 11a of the compound semiconductor layer 11 in the first direction (x-axis direction in the figures), crossing a line connecting the adjacent openings 111 in the second direction (y-axis direction in the figures).

Accordingly, the first finger electrodes 13b1 may be formed to have the first length shorter than a width (based on the x-axis in the figures) of the compound semiconductor layer 11, thus having a rectangular shape having a longer side extending substantially in the second direction.

Meanwhile, each one of the second finger electrodes 13b2 may be formed adjacent to the opening 111, extending in the first direction, and spaced apart from the first longitudinal side 11a, so as to have the second length shorter than the first length.

According to the example illustrated in FIG. 6, the charge may be collected more effectively than in the embodiment illustrated in FIG. 4. In the embodiment illustrated in FIG. 4, it takes time for the charges generated at the first longitudinal side 11a to move to the finger electrodes 13b, because all of the finger electrodes 13b are formed to have the second length. On the other hand, because the first finger electrodes 13b1 in the example of FIG. 6 are located near the first longitudinal side 11a, the charges may be effectively collected.

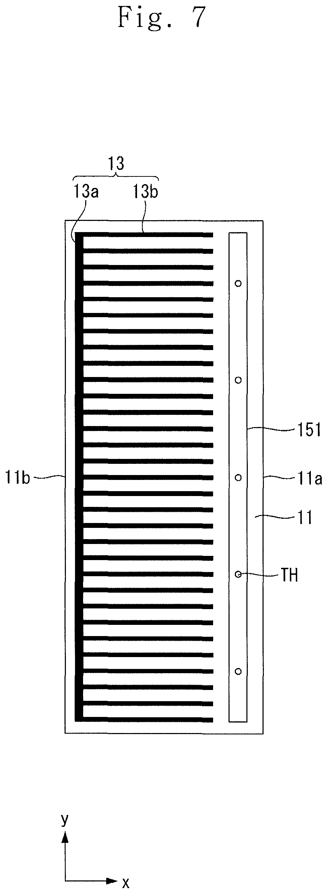

FIG. 7 illustrates one example in which an opening 151 may be formed as a whole without being formed to correspond to each of the through holes TH. In this example, the opening 151 may be formed to have a long slit shape in the second direction.

The plurality of through-holes TH may be disposed along the opening 151 at regular intervals in the second direction.

According to the example illustrated in FIG. 7, because the opening 151 is not formed to correspond to each through hole TH but is formed as a single opening to correspond to all of the through holes TH, it is possible to sufficiently secure the area in which the conductive layer and the second electrode 15 may be in contact with each other. As a result, the contact resistance may be reduced and the bonding force may be increased.

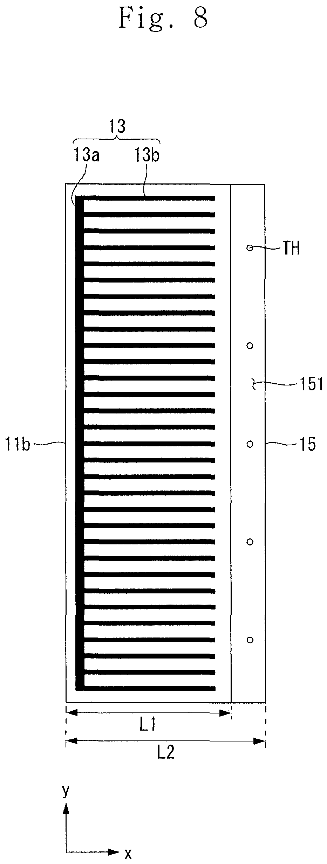

FIG. 8 illustrates an example in which the opening 151 is formed to expose the entire side of the second electrode 15 in the second direction. As illustrated in FIG. 8, the compound semiconductor layer 11 may be formed to have the first width L1 in the first direction, while the second electrode 15 may be formed to have the second width L2 in the first direction larger than the first width L1. Accordingly, a part of the second electrode 15 corresponding to the difference between the first width L 1 and the second width L 2 may be exposed by the opening 151. A plurality of through holes TH may be arranged along the opening 151 at regular intervals in the second direction.

According to the example illustrated in FIG. 8, the through hole TH is completely exposed to the outside. Thus, when a conductive adhesive is applied to the through hole TH with a dispensing process, the process may be performed with a sufficient working margin, and it is easy to form the opening 151 with a mesa etching process.

In some embodiments, the opening 151 may be formed with the mesa etching processing, and the through hole TH may be formed during a scribing process. The through hole TH may also be formed by a method such as laser drilling, or mechanical drilling (or punching) using a machine.

Here, the mesa etching process refers to a process in which the compound semiconductor layer is selectively etched using an etchant to divide the compound semiconductor layer into cell units. The scribing process refers to a process in which a plurality of compound semiconductor solar cells are separated in a cell unit by scribing a rear electrode exposed by mesa etching after the mesa etching process.

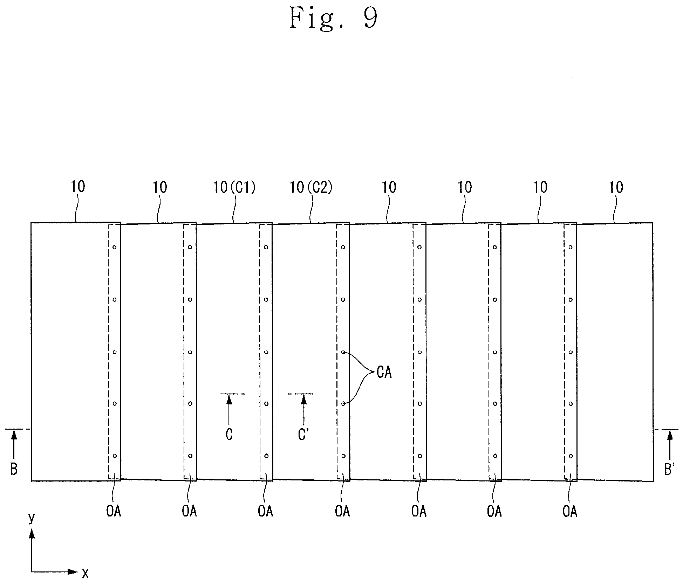

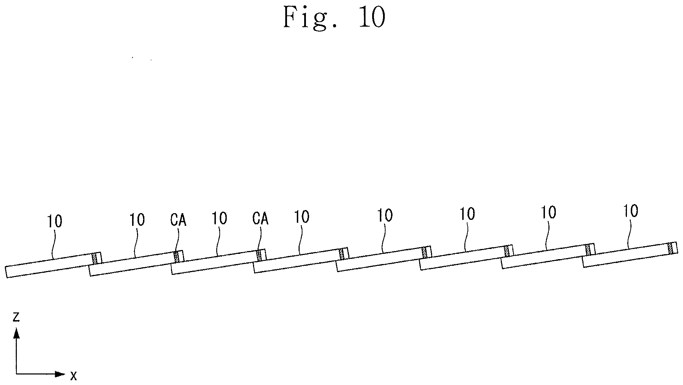

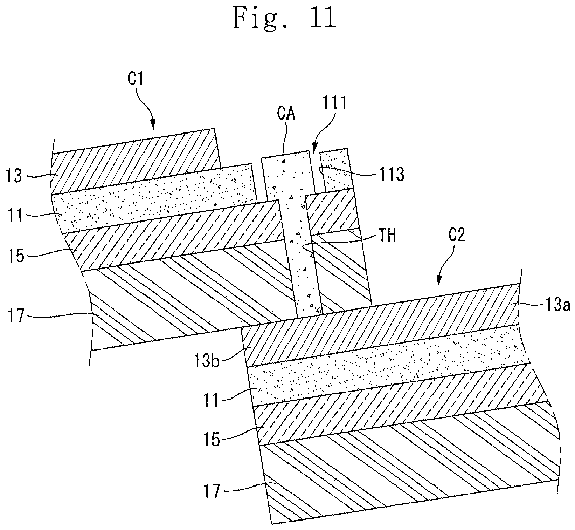

FIG. 9 is a view illustrating a compound solar cell module in which a compound solar cell illustrated in FIG. 1 may be used. FIGS. 10 and 11 are views illustrating cross-sectional views taken along line B-B' and line C-C' in FIG. 8, respectively.

A compound solar cell module according to an embodiment of the disclosure will be described with Reference to FIGS. 9 to 11.

The compound solar cell module according to the embodiment of the disclosure may be physically and electrically connected by overlapping a plurality of compound solar cells 10 in overlap regions OA. As shown in the figures, when two solar cells neighboring in the first direction (x-axis direction in the figures) are referred to as a first solar cell C1 and a second solar cell C2, respectively, a part of the rear surface of the first solar cell C1 and a part of the front surface of the second solar cell C2 may be overlapped and electrically and physically connected by a conductive layer CA.

Here, the conductive layer CA may be formed by curing a solder or a conductive adhesive. The conductive adhesive may be composed of a polymer base material (for example, epoxy, acrylate, silicone, etc.) and conductive filler particles, and bonds and conducts between members by mechanical and physical contact of the conductive filler particles. The solder may have a paste form or a cream phase which is made by mixing a solder powder and a flux. The solder powder melts at a melting point or higher. The solder mechanically and electrically bonds with a base material while cooling. The solder powder may include at least one solder selected from the group consisting of Sn-Cu, Sn-Ag, Sn-Ag-Cu, Sn-Ag-Bi, Sn- Sn-Bi system, Sn-In system solder, and the like. In the disclosure, unless otherwise specified, materials used for bonding and conducting between two members are collectively referred to as a conductive adhesive.

In an embodiment, the portion where the first solar cell C1 and the second solar cell C2 may be overlapped and bonded with a non-conductive adhesive having a relatively high bonding strength but no conductivity such as PSA (Pressure Sensitive Adhesive) adhesive, epoxy adhesive, acrylate adhesive, and silicone adhesive.

By bonding the portion where the first solar cell C1 and the second solar cell C2 may be overlapped with the non-conductive adhesive, the low bonding force of the conductive adhesive may be supplemented to bond the first solar cell C1 and the second solar cell C2. This makes it possible to more firmly connect the cells C1 and C2.

The first solar cell C1 may be overlapped with a part of the second solar cell C2 in the overlap region OA in the longitudinal direction (y axis direction in the figures). The through hole TH formed in the first solar cell C1 may be positioned above the bus electrode 13a of the front electrode 13 formed on the front surface of the second solar cell C2.

One side of the conductive layer CA fills the through hole TH of the first solar cell C1 and may be in contact with the bus electrode 13a of the second solar cell C2, the other side of the conductive layer CA may be formed over the second electrode 15 exposed by the opening 111 of the first solar cell C1. The conductive layer CA electrically connects the second electrode 15 of the first solar cell C1 and the first electrode 13 of the second solar cell C2 and physically connects the first solar cell C1 and the second solar cell C2 in the overlap region OA.

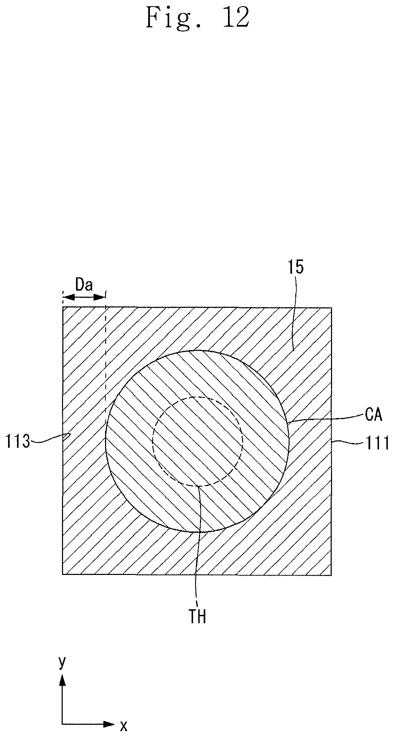

FIG. 12 is a view for explaining the arrangement between an opening and a conductive layer. As illustrated in FIG. 12, the conductive layer CA may be formed to be larger than the through hole TH, so that it may be connected to the second electrode 15 exposed through the opening 111. The conductive layer CA may be formed at a predetermined distance Da from a side surface 113 of the compound semiconductor layer 11.

In an embodiment, an insulating layer may be further formed between the conductive layer CA and the side surface 113 of the compound semiconductor layer 11 to prevent electrical connection therebetween. Here, the insulating layer may be formed not only of silicon nitride, silicon oxide, etc., but also of an insulating layer by applying a non-conductive adhesive along the side surface 113 and then curing it. The insulating layer may surround the side surface 113 of the compound semiconductor layer 11, or may be formed on the exposed second electrode 15 between the side surface 113 of the compound semiconductor layer 11 and the conductive layer CA.

Hereinafter, a method of manufacturing a compound solar cell and a compound solar cell module formed as described above will be described. A general method for manufacturing a compound solar cell well known in the art may include a step of forming a stack including a compound semiconductor layer, a first electrode and a second electrode respectively formed on front and back surfaces of the compound semiconductor layer, and a support substrate formed on the second electrode; a step of mesa etching; and a step of scribing.

The compound semiconductor layer 11 may be formed by forming a sacrificial layer on one side of a mother substrate serving as a base for providing an appropriate lattice structure, forming various layers made of a compound semiconductor as shown in FIG. 2 including a rear contact layer 115, a p-type semiconductor layer PV-p, an n-type semiconductor layer PV-n, a window layer 117, and a front contact layer 119, that are successively grown on the sacrificial layer, and removing the various layers from the mother substrate by an ELO (epitaxial lift off).

The sacrificial layer and the compound semiconductor layer may be formed by a metalorganic chemical vapor deposition (MOCVD) method, a molecular beam epitaxy (MBE) method, or any other suitable method for forming an epitaxial layer.

A second electrode 15 having a sheet shape layer may be formed on the rear surface of the compound semiconductor layer 11 and a plurality of first electrodes 13 may be formed on the front surface of the compound semiconductor layer 11.

Since the step of forming the stack is well known in the art, a detailed description of the steps is omitted.

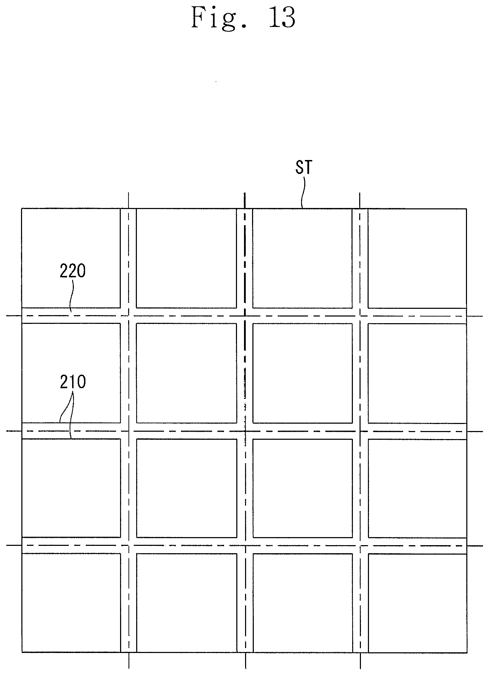

The stack ST may be divided into a plurality of compound solar cells by mesa etching and scribing the stack ST as illustrated in FIG. 13. As illustrated in FIG. 13, mesa etching refers to a process of dividing a stack ST into a plurality of compound solar cells by forming a mesa line 210 that exposes a part of the compound semiconductor layer 11. The scribing process refer to a process in which a plurality of compound semiconductor solar cells are separated in a cell unit by irradiating (or mechanically cutting) the laser along a scribe line 220 located above the mesa line 210.

The method of manufacturing a compound solar cell according to an embodiment of the disclosure includes, after formation of a stack ST, forming an opening 111 in a compound semiconductor layer 11, and forming a mesa line 210 that divides the opening 111 into a plurality of cells. The opening 111 and the mesa line 210 may be formed simultaneously with the mesa etching process.

The method for manufacturing a compound solar cell according to an embodiment of the disclosure includes, after forming the opening 111, forming a through hole TH by removing a second electrode 15 and a support substrate 17 positioned under the opening, and scribing the stack ST into a plurality of solar cells along the mesa line. The through hole TH may be formed simultaneously with the scribing process.

According to these methods, an opening 111 may be formed through mesa etching without adding a new process in the conventional method of manufacturing a compound solar cell, and the through hole TH may be formed through the scribing process. It is thus possible to simplify the manufacturing method of the compound solar cell and thereby to reduce the manufacturing cost.

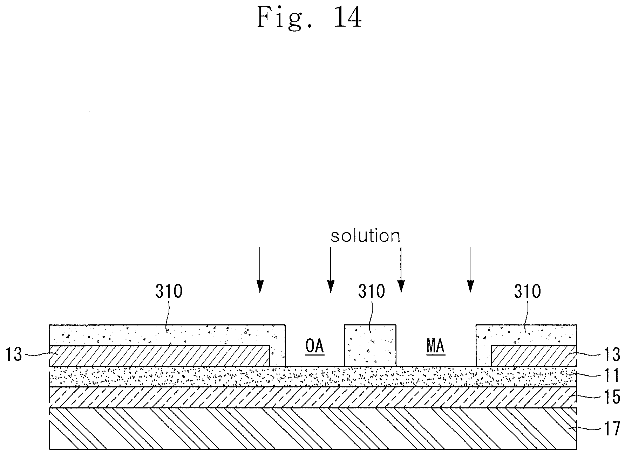

First, a method of forming an opening by mesa etching will be described with reference to FIG. 14. In the method of FIG. 14, an etch stop layer 310 may be formed on the patterned first electrode 13. The etch stop layer 310 may be formed to be thick enough to cover the first electrode 13 and functions to protect the first electrode 13 patterned in the mesa etching process.

Any one material selected from a polymer, an epoxy, a wax, a resin, and a photoresist having a viscosity of 50 to 1,000 cP at room temperature may be coated on the front surface of the first electrode 13. Here, a spin coating method may be used for the coating of the material.

After the etch stop layer 310 is formed on the entire surface of the stack ST as described above, a portion of the etch stop layer 310 positioned on an open region OA where the opening 111 is to be formed and a mesa region MA where the mesa line 210 is to be formed may be removed to expose the compound semiconductor layer 11 to the outside.

Next, the compound semiconductor layer 11 exposed through the open area OA and the mesa area MA may be exposed to a solution using the etch stop layer 310 as a barrier to partially remove the compound semiconductor layer 11. As a result, the opening 111 and the mesa line 210 are formed.

The etching process includes a first etching process using a first solution containing hydrochloric acid (HCl), a second etching process including a mixed solution of ammonium hydroxide (NH4OH) / hydrogen peroxide (H2O2) / deionized water (DI), and a third etching process using a third solution different from the first solution and the second solution.

Here, the first solution may be used to remove the layer formed of GaInP, AlInP, AlGaInP among the various layers contained in the compound semiconductor layer (CS). The second solution may be used to remove the layer formed of GaAs, AlGaAs among the various layers contained in the compound semiconductor layer (CS). The third solution may be a mixed solution of phosphoric acid (H3PO4) / hydrogen peroxide (H2O2) / deionized water (DI) having a material which forms the second electrode, for example, silver (Ag).

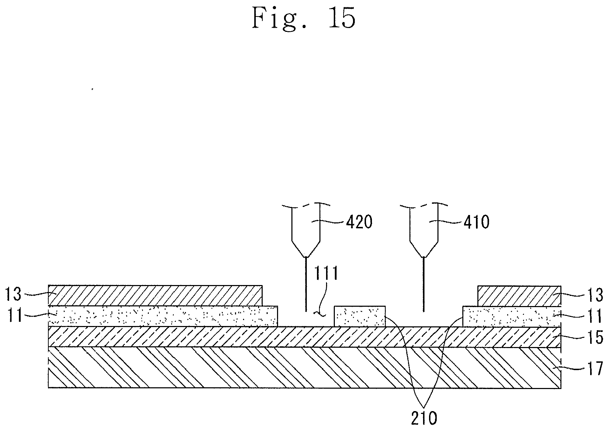

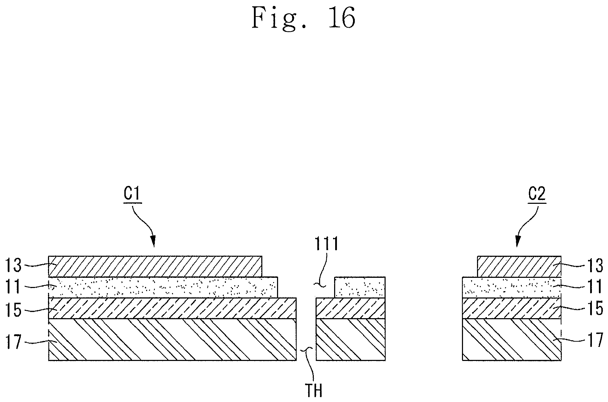

Hereinafter, a method of forming a through hole through a scribing process will be described with reference to FIGS. 15 and 16.

In an embodiment, a laser is used to cut the stack. The laser used in this scribing process may be a UV laser of 1 watt (W) to 3 W in order to clearly remove the support substrate 17 formed of a PET (polyethylene terephthalate) film in general. If the laser intensity is less than 1 watt, burrs may occur while the support substrate 17 is being laser drilled. If the intensity of the laser is greater than 3 watts, the support substrate 17 may be scraped off, which is undesirable. For this reason, it may be desirable that a UV laser of 1 W to 3 W is used for the laser, but the disclosure is not necessarily limited to this, and various types of lasers may be used to remove the second electrode 15 and the support substrate 17 by laser drilling.

The scribing process may be performed by a first laser irradiator 410 and a second laser irradiator 420. The first laser irradiator 410 may irradiate a laser along the mesa line 210 to divide the stack into a plurality of compound solar cells. The first laser irradiator 410 may irradiate the laser toward the mesa line 210 according to a programmed procedure.

The second laser irradiator 420 may irradiate a laser in the vertical direction of the opening 111 to remove the second electrode 15 and the support substrate 17 located under the opening 111, to form a through hole TH in the lower part of the opening 111. The second laser irradiator 420 may also be configured to emit a laser for each opening 111 according to a programmed procedure. The second laser irradiator 420 may be implemented to irradiate a UV laser of 1 W to 3 W as described above.

The through hole TH may be formed by irradiating the laser beam several times to several tens of times, rather than irradiating the laser beam once. In order to form the through hole TH by irradiating the laser once, it may be necessary to irradiate a laser with a high power, and the compound semiconductor layer 11 may be easily damaged by such a high power laser, which is not desirable. For this reason, it may be desirable to form the through hole TH by irradiating the laser with a low power several times or several tens of times to prevent the compound semiconductor layer 11 from being thermally damaged.

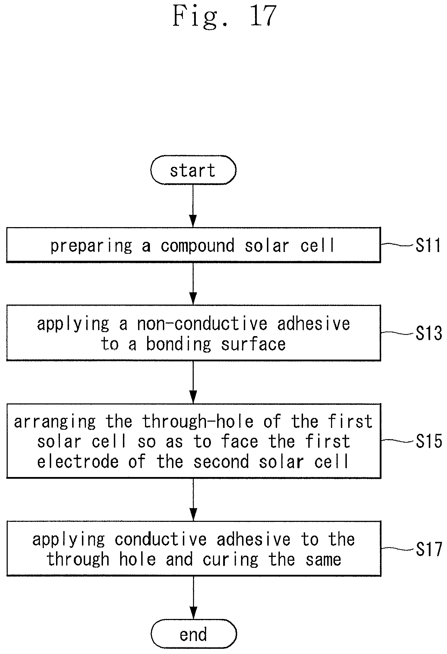

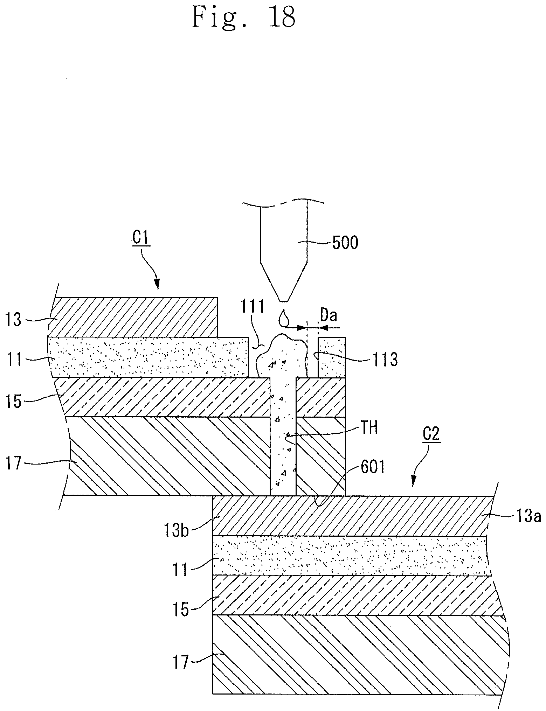

Hereinafter, with reference to FIGS. 17 and 18, a method of manufacturing a compound solar cell module according to an embodiment of the disclosure will be described. Referring to FIGS. 17 and 18, a method of manufacturing a compound solar cell module according to an embodiment of the disclosure includes a step S1 of preparing a compound solar cell, a step S13 of applying a non-conductive adhesive to a bonding surface, a step S15 of arranging the through-hole of the first solar cell so as to face the first electrode of the second solar cell S15, and a step S17 of applying a conductive adhesive to the through hole and curing the same.

The step S11 of preparing the compound solar cells may be performed by the method of manufacturing the compound solar cell described above with reference to FIGS. 1 to 8, so that a detailed description thereof will not be repeated.

In steps S13 and S15, when the first solar cell C1 and the second solar cell C2 may be partially overlapped, the lower part of the first solar cell C1 in which the through hole TH is formed (that is, a part of the rear surface of the support substrate 17) and a first electrode 13 of the second solar cell C2 (that is, the front surface of the first electrode 13 of the second solar cell C2) may be arranged to face each other. As a result, a bonding surface 601 is formed.

In one embodiment, a non-conductive adhesive may be applied to the bonding surface 601. In order to simplify the process, the non-conductive adhesive applied to the bonding surface 601 may be cured at the same time as the step of applying and curing the conductive adhesive in step S17. In the present embodiment, however, the non-conductive adhesive applied to the bonding surface 601 may be applied and followed immediately by curing. When the application and curing are continuously performed as described above, the first solar cell C1 and the second solar cell C2 are firmly fixed, so that it is possible to more accurately apply the conductive adhesive in the step S17.

The non-conductive adhesive may be applied to the bonding surface 601 except for the portion where the through hole TH is formed, and the non-conductive adhesive may be applied to the rear surface of the support substrate 17 of the first solar cell C1, and/or the first electrode 13 of the second solar cell C2.

In step S17, the conductive adhesive may be applied to the through hole TH through the dispenser 500. The conductive adhesive supplied to fill the through hole TH through the dispenser 500 may fill at least a part of the opening 111 and reach the surface of the second electrode 15 exposed through the opening 111.

The conductive adhesive may be formed on the surface of the second electrode 15 so that the bonding are is sufficient to ensure adequate conductivity between the first solar cell C1 and the second solar cell C2. Because the second electrode 15 may have a very thin thickness of about 5 um or less, when the conductive adhesive is simply filled in the through hole TH, there may be a problem that a junction area and a conductive path are small and the resistance increases. In consideration of this problem, the conductive adhesive may be formed on the surface of the second electrode 15 exposed through the opening 111 to fill at least a part of the opening 111.

The conductive adhesive formed up to the opening 111 may be formed so as to be spaced apart from the side surface 113 of the opening 111 by a predetermined distance Da. If the conductive adhesive is formed to the side wall surface, the compound semiconductor layer 11 may be short-circuited.

In consideration of such a problem, the conductive adhesive may have a viscosity of 8,000 cps to 12,000 cps. When the viscosity is less than 8,000 cps, the viscosity of the conductive adhesive may be too high and the conductive adhesive may be supplied to the side surface 113 of the opening 111 while applying the conductive adhesive. When the viscosity is larger than 12,000 cps, the viscosity is not so high, and the through hole TH may become clogged and the conductive adhesive not properly supplied to the through hole TH.

Thereafter, the conductive adhesive may be cured by a heat source such as UV or heat.

Although embodiments have been described with reference to a number of illustrative embodiments thereof, it should be understood that numerous other modifications and embodiments may be devised by those skilled in the art that will fall within the scope of the principles of this disclosure. More particularly, various variations and modifications are possible in the component parts and/or arrangements of the subject combination arrangement within the scope of the disclosure, the drawings and the appended claims. While the exemplary methods are described herein as a series of steps, it is to be understood that the steps of the disclosed methods may be modified in any manner, including by reordering steps and/or inserting or deleting steps. In particular, non-dependent steps may be performed in any order, or in parallel. In addition to variations and modifications in the component parts and/or arrangements, alternative uses will also be apparent to those skilled in the art.

## Claims

1. A compound solar cell, comprising:
a compound, semiconductor layer;
a first electrode and a second electrode respectively formed on a first surface and a second surface of the compound semiconductor layer;
a support substrate formed on the second electrode;
an opening formed in the compound semiconductor layer, the opening positioned along a first longitudinal side of the compound semiconductor layer to expose the second electrode; and
a through hole connected to the opening and formed to penetrate the second electrode and the support substrate.

2. The compound solar cell of claim 1, wherein the first electrode comprise:
a bus electrode formed to extend along a second longitudinal side opposite to the first longitudinal side, and
a finger electrode formed to extend from the bus electrode toward the first longitudinal side.

3. The compound solar cell of claim 2, wherein the opening is positioned apart from the finger electrode in a longitudinal direction of the finger electrode.

4. The compound solar cell of claim 2 or 3, wherein:
the finger electrode is one of a plurality of finger electrodes formed to extend from the bus electrode toward the first longitudinal side; and
the opening is positioned between two finger electrodes.

5. The compound solar cell of claim 4, wherein the plurality of finger electrodes comprises:
at least one first finger electrode having a first length and extending between the openings to the first longitudinal side; and
at least one second finger electrode extending toward the openings and having a second length shorter than the first length.

6. The compound solar cell of any one preceding claim, wherein the opening extends along the first longitudinal side and has a slit shape.

7. The compound solar cell of any one preceding claim, wherein the opening exposes an entire side of the second electrode in a longitudinal direction.

8. A compound solar cell module comprising a plurality of solar cells partially overlapped in overlap regions, wherein each one of the plurality of solar cells comprises:
a compound semiconductor layer;
a first electrode and a second electrode respectively formed on a first surface and a second surface of the compound semiconductor layer;
an opening formed in the compound semiconductor layer, the opening positioned along a first longitudinal side of the compound semiconductor layer to expose the second electrode; and
a through hole connected to the opening and formed to penetrate the second electrode and the support substrate,
wherein the through hole of a first solar cell among the plurality of solar cells is positioned on the first electrode of a second solar cell among the plurality of solar cells in an overlap region of the first solar cell and the second solar cell, and
the first solar cell and the second solar cell are electrically and physically connected by a conductive layer filling the through hole of the first solar cell.

9. The compound solar cell module of claim 8, wherein the conductive layer is formed to extend over the second electrode of the first solar cell partially exposed through the opening of the first solar cell, and is positioned apart from a side surface of the through hole of the compound semiconductor layer of the first solar cell.

10. The compound solar cell module of claim 8 or 9, wherein the first solar cell and the second solar cell are bonded by a non-conductive adhesive in the overlap region.

11. A method for manufacturing a compound solar cell, the method comprising:
forming a stack including a compound semiconductor layer, a first electrode and a second electrode respectively formed on front and back surfaces of the compound semiconductor layer, and a support substrate formed on the second electrode;
forming an opening that partially exposes the second electrode;
forming a mesa line dividing the stack into a plurality of cells;
forming a through hole by removing a portion of the second electrode and a portion of the support substrate positioned under the opening; and
scribing the stack into a plurality of solar cells along the mesa line.

12. The method for manufacturing a compound solar cell of claim 11, wherein the operation of forming the mesa line and the operation of forming the opening are simultaneously performed by a mesa etching process.

13. The method for manufacturing a compound solar cell of claim 11 or 12, wherein the operation of scribing the stack and the operation of forming the through hole are simultaneously performed by a laser scribing process.

14. A method for manufacturing a compound solar cell module comprising a plurality of compound solar cells respectively having a compound semiconductor layer, a first electrode and a second electrode respectively formed on a first surface and a second surface of the compound semiconductor layer, a support substrate formed on the second electrode, an opening formed in the compound semiconductor layer, the opening positioned along a first longitudinal side of the compound semiconductor layer to expose the second electrode, and a through hole connected to the opening and formed to penetrate the second electrode and the support substrate, the method comprising:
disposing the through hole of a first solar cell among the plurality of solar cells toward the first electrode of a second solar cell among the plurality of solar cells; and
applying and curing a conductive adhesive to the through hole of the first solar cell,
wherein the conductive adhesive fills a part of the opening of the first solar cell and is formed on a surface of the second electrode of the first solar cell exposed by the opening of the first solar cell.

15. The method for manufacturing a compound solar cell of claim 14, wherein the conductive adhesive has a viscosity of 8,000 cps to 12,000 cps.
